(19) Europäisches Patentamt / European Patent Office / Office européen des brevets

(11) **EP 1 997 205 B1**

(12) **EUROPÄISCHE PATENTSCHRIFT**

(45) Veröffentlichungstag und Bekanntmachung des Hinweises auf die Patenterteilung:
**16.08.2017   Patentblatt 2017/33**

(21) Anmeldenummer: **06723390.8**

(22) Anmeldetag: **14.03.2006**

(51) Int Cl.:
**H02J 7/00** *(2006.01)*

(86) Internationale Anmeldenummer:
**PCT/EP2006/002291**

(87) Internationale Veröffentlichungsnummer:
**WO 2007/104325 (20.09.2007 Gazette 2007/38)**

(54) **ENERGIESPEICHER-DIAGNOSESCHALTUNG**

DIAGNOSTIC CIRCUIT FOR AN ENERGY STORAGE ELEMENT

MONTAGE DIAGNOSTIQUE POUR ACCUMULATEUR D'ÉNERGIE

(84) Benannte Vertragsstaaten:
**DE ES FR GB IT SE**

(43) Veröffentlichungstag der Anmeldung:
**03.12.2008   Patentblatt 2008/49**

(73) Patentinhaber: **Bayerische Motoren Werke Aktiengesellschaft**
**80809 München (DE)**

(72) Erfinder:
• **FROESCHL, Joachim**
**82211 Herrsching (DE)**
• **LUTZ, Steffen**
**85757 Karlsfeld (DE)**
• **WAGNER, Robert**
**85551 Kirchheim (DE)**
• **HOEFFER VON LOEWENFELD, Maximilian**
**81825 München (DE)**

(74) Vertreter: **Bullwein, Fritz et al**
**Bayerische Motoren Werke AG**
**Patentabteilung AJ-5**
**80788 München (DE)**

(56) Entgegenhaltungen:
EP-A2- 0 798 839     EP-A2- 0 851 556
US-A- 6 114 835       US-A1- 2003 015 995

**Beschreibung**

Die Erfindung betrifft eine Energiespeicher-Diagnoseschaltung für eine Zellgruppe in einem Zellenverbund eines Energiespeichers, insbesondere eines Energiespeichers in einem Kraftfahrzeug-Bordnetz. Weiter betrifft die Erfindung ein Verfahren zur Regenerierung eines aus in Reihe geschalteten Zellgruppen bestehenden Zellverbunds eines Energiespeichers.

Im Automobilbereich kommen immer mehr aus Einzelzellen aufgebaute Energiespeicher, vorzugsweise aus Doppelschichtkondensatoren aufgebaute Energiespeicher zum Einsatz. Diese Doppelschichtkondensatoren bieten bei der Bereitstellung und Speicherung von Energie den Vorteil, dass sie kurzfristig hohe Leistung zur Verfügung stellen können. Um auf die in einem Kraftfahrzeug notwendige Versorgungsspannung zu kommen, müssen die einzelnen Doppelschichtkondensatoren in Reihe geschaltet werden. Die in Reihe geschalteten Zellen bilden somit einen Zellenverbund. Zum Laden, zur Symmetrierung der Zellspannung, zur Erkennung von Unter- und Überspannung einzelner Zellen, zur Ladungserhaltung der Zellen im Standbetrieb, zum Auf- und Entladen bzw. Umladen zwischen den einzelnen Zellen sowie zur Diagnose/Monitoring der einzelnen Zellen werden einzelne Zellen oder Zellgruppen überwacht. Es ist bekannt, dass hierfür Zellgruppen-Logiken vorgesehen werden, die jeweils mit einer Zellgruppe verbunden sind, um deren Spannung zu überwachen und/oder zu steuern oder zu regeln. Eine Zellgruppe kann auch lediglich aus einer Einzelzelle bestehen. Damit die Zellspannungen der einzelnen Zellen bzw. Zellgruppen beim zyklischen Laden oder Entladen nicht auseinanderlaufen, ist es bekannt, die Zellgruppen-Logiken mittels einer übergeordneten Regelungseinrichtung, z.B. einer Zentral-Logik, zu überwachen und so anzusteuern, dass ein gleichmäßiges Laden und/oder Entladen erreicht wird, wodurch eine lange Lebensdauer der einzelnen Zellen und somit des gesamten Zellenverbunds erreicht werden kann.

Aus der DE 100 99 407 A1 ist weiter eine Symmetrierschaltung für in Reihe geschaltete elektrische Energiespeicherelemente bekannt, die mittels relativ geringem Aufwand ein Überladen der Energiespeicherelemente verhindert. Hier ist jedes Energiespeicherelement mit einer Bypassschaltung zum Begrenzen der Ladespannung versehen, welche eine vom Energiespeicherelement gespeiste, spannungsgesteuerte Stromquelle zum Generieren eines Bypassstroms enthält. Die Bypassschaltung nimmt also ab einem voreingestellten Wert für die Nennspannung einen zunehmenden Anteil des Ladestroms auf und schützt so das jeweilige Energiespeicherelement vor einer Überlastung.

Außerdem ist ein Verfahren gemäß dem Oberbegriff des Anspruchs 1 aus der EP 0 851 556 A2 bekannt.

Nachteilig an dieser im Vergleich mit den zuvor beschriebenen Zellgruppen-Logiken im Bezug auf die Herstellungskosten sehr günstigen Lösung ist, dass keinerlei Diagnosefunktion vorgesehen ist. Aufgabe der Erfindung ist es, eine einfach aufgebaute Energiespeicher-Diagnoseschaltung für eine Zellgruppe in einem Zellenverbund eines Energiespeichers sowie ein Verfahren zur Regenerierung eines aus in Reihe geschalteten Zellgruppen bestehenden Zellenverbunds eines Energiespeichers auf Basis der von der Energiespeicher-Diagnoseschaltung ausgeführten Diagnose bereitzustellen.

Diese Aufgabe wird erfindungsgemäss durch ein Verfahren zur Regenerierung eines aus in Reihe geschalteten Zellgruppen bestehenden Zellenverbunds eines Energiespeichers nach Patentanspruch 1 gelöst.

Die nachfolgend beschriebene Energiespeicher-Diagnoseschaltung ist nicht vom Umfang der Ansprüche umfasst und wird lediglich für ein besseres Verstädnis der Erfindung erklärt.

Die Energiespeicher-Diagnoseschaltung für eine Zellgruppe in einem Zellenverbund eines Energiespeichers, insbesondere eines Energiespeichers in einem Kraftfahrzeug-Bordnetz, wobei die Energiespeicher-Diagnoseschaltung mit Spannungsanschlüssen der Zellengruppe verbunden ist, zeichnet sich dadurch aus, dass die Energiespeicher-Diagnoseschaltung, wenn eine an den Spannungsanschlüssen der Zellgruppe anliegende Zellgruppenspannung einen ersten Schwellenpegel überschreitet und/oder wenn die Zellgruppenspannung einen zweiten Schwellenpegel unterschreitet, einen bestimmten Spannungspegel und/oder Strom auf eine Diagnose-Rail einprägt, über die wenigstens ein überwachter Betriebsparameter der Zellgruppe und/oder des Zellenverbunds abgefragt werden kann.

Hierbei werden vorzugsweise bei Überschreiten und Unterschreiten der Zellgruppenspannung die gleichen Pegel auf die Diagnose-Rail eingeprägt, es können aber auch unterschiedliche Pegel eingeprägt werden. Die Zellgruppen können jeweils auch aus einer Einzelzelle bestehen. Der eingeprägte Spannungspegel bzw. Strom kann hier demzufolge als ein auf der Diagnose-Rail gesetztes Flag für Überschreiten oder Unterschreiten bzw. jeweils für Überschreiten und Unterschreiten angesehen werden.

Die Diagnose-Rail besteht hier vorzugsweise aus einer Leitung und Masse. Es können als Diagnose-Rail jedoch auch mehrere Leitungen oder mehrere Leitungen und Masse vorgesehen sein. In diesem Fall kann z.B. bei Überschreiten der Zellgruppenspannung ein bestimmter Spannungspegel oder Strom auf eine Leitung eingeprägt werden und bei Unterschreiten kann der oder ein anderer bestimmter Spannungspegel oder Strom auf eine andere Leitung eingeprägt werden.

Weiter können über die Höhe des bestimmten Spannungspegels oder Stroms oder über eine Frequenzmodulation oder Pulsweitenmodulation noch weitere Informationen übertragen werden, z.B. die Anzahl der Zellen des Zellenverbunds und/oder die Anzahl der Zellen einer Zellgruppe und/oder ein Identifikator einer Zelle oder Zellgruppe mit Unter- bzw. Überspannung und/oder ob ein Unter- oder ein Überschreiten der Zellgruppenspannung vorliegt.

Das erfindungsgemäße Verfahren zur Regenerierung eines aus in Reihe geschalteten Zellgruppen bestehenden Zellenverbunds eines Energiespeichers mittels Energiespeicher-Diagnoseschaltungen, die an die Zellgruppen angeschlossen sind, wobei jede Energiespeicher-Diagnoseschaltung bei Vorliegen einer Überspannung oder einer Unterspannung der daran angeschlossenen Zellgruppe ein Flag ausgibt, umfasst die folgenden Schritte:

a) Detektieren des Vorliegens wenigstens eines Flags,

b) Bewerten, ob eine Über- oder eine Unterspannung vorliegt und Setzen eines Merkers über das Vorliegen einer Über- oder Unterspannung,

c) Überprüfen, ob nur Überspannungen oder nur Unterspannungen aufgetreten sind,

d) liegen nur Überspannungen oder nur Unterspannungen vor, Überprüfen, ob noch ein Flag anliegt; wenn gerade kein Flag anliegt, Starten einer Regenerierung; wenn gerade ein Flag anliegt, Überprüfen, ob ein Defekt vorliegt, Starten einer Regenerierung bei keinem Defekt und Starten eines Notfallverfahrens bei einem Defekt, und

e) liegen Überspannungen und Unterspannungen vor, Regeln der Spannung des Zellenverbunds auf eine bestimmte Spannung, Überprüfen, ob noch ein Flag anliegt; wenn gerade kein Flag anliegt, Starten einer Regenerierung; wenn gerade ein Flag anliegt, Starten eines Notfallverfahrens.

Das erfindungsgemäße Verfahren bietet demzufolge im Zusammenhang mit der erfindungsgemäßen Energiespeicher-Diagnoseschaltung die Möglichkeit, Defekte des Zellenverbunds eines Energiespeichers festzustellen und abhängig davon eine Regenerierung bzw. ein Notfallverfahren zu starten. Dies bietet gegenüber dem Stand der Technik bei unwesentlich erhöhtem Hardware-Aufwand eine verbesserte Ladungserhaltung und Symmetrierung der Einzelzellen des Zellenverbunds, wodurch eine erhöhte Lebensdauer des gesamten Zellenverbunds erreicht wird.

Die abhängigen Patentansprüche zeigen vorteilhafte Weiterbildungen der im Patentanspruch 1 definierten Energiespeicher-Diagnoseschaltung und des im Patentanspruch 6 definierten Verfahrens zur Regenerierung eines aus in Reihe geschalteten Zellgruppen bestehenden Zellenverbunds eines Energiespeichers mittels Energiespeicher-Diagnoseschaltungen.

Vorteilhafterweise ist die erfindungsgemäße Energiespeicher-Diagnoseschaltung in einer aktiv-bypass Symmetrierschaltung integriert. In diesem Fall können wesentliche Schaltungselemente der erfindungsgemäßen Energiespeicher-Diagnoseschaltung durch die aktiv-bypass Symmetrierschaltung gebildet werden, hier insbesondere ein Komparator sowie ein Schaltungsteil zur Bildung eines Schwellenpegels.

Bei der erfindungsgemäßen Energiespeicher-Diagnoseschaltung werden der erste Schwellenpegel und/oder der zweite Schwellenpegel vorteilhafterweise aus der Zellgruppenspannung gewonnen. Alternativ werden diese vorteilhafterweise aus einer an der Diagnose-Rail anliegenden Hilfsspannung gewonnen

Erfindungsgemäß wird über die Diagnose-Rail als ein überwachter Betriebsparameter der Zellgruppe und/oder des Zellenverbunds vorteilhafterweise wenigstens die Temperatur wenigstens einer Zellgruppe oder des Zellenverbunds abgefragt.

Somit wird erfindungsgemäß vorzugsweise eine eingesetzte aktiv-bypass Symmetrierschaltung um eine Diagnosefunktion erweitert und das Diagnoseergebnis auf eine in dem Zellenverbund vorhandene Diagnose-Rail ausgegeben. Die erfindungsgemäße Energiespeicher-Diagnoseschaltung bietet somit eine Minimaldiagnose für Speichermodule, wobei die Auswertung des Diagnoseergebnisses auf der Diagnose-Rail bevorzugt außerhalb oder bei Bedarf auch innerhalb des Speichermoduls, insbesondere durch ein Steuergerät mit einem Mikroprozessor erfolgt. Durch das erfindungsgemäße Verfahren zur Regenerierung des Zellenverbunds wird das Diagnoseergebnis der erfindungsgemäßen Energiespeicher-Diagnoseschaltung ausgewertet und so verarbeitet, dass eine diagnoseabhängige Regenerierung erfolgt, wobei die Regenerierung an sich vorzugsweise mittels aktiv-bypass Symmetrierschaltungen für die Zellgruppen des Zellenverbunds erfolgt. Wie zuvor dargelegt, kann eine Zellgruppe auch aus lediglich einer Einzelzelle bestehen.

Bei dem erfindungsgemäßen Verfahren werden vorzugsweise die folgenden Schritte ausgeführt, um im Schritt d) zu überprüfen, ob ein Defekt vorliegt:

d1) bei ausschließlichem Vorliegen von Überspannungen, Absenken der Spannung des Zellenverbunds und Überprüfen, ob das gerade anliegende Flag fällt, bevor die Spannung des Zellenverbunds unter einen ersten kritischen Wert gefallen ist; ist dies der Fall, liegt kein Defekt vor, ist dies nicht der Fall, liegt ein Defekt vor, und

d2) bei ausschließlichem Vorliegen von Unterspannungen, Anheben der Spannung des Zellenverbunds und Überprüfen, ob das gerade anliegende Flag fällt, bevor die Spannung des Zellenverbunds über einen zweiten kritischen Wert gestiegen ist; ist dies der Fall, liegt kein Defekt vor, ist dies nicht der Fall, liegt ein Defekt vor.

Die Bewertung im Schritt b), ob eine Über- oder Unterspannung vorliegt, wird erfindungsgemäß vorzugsweise durch die folgenden Schritte ausgeführt:

b1) Feststellen einer Überspannung, wenn ein Flag vorliegt und die Spannung des Zellenverbunds über einer ersten Spannungsschwelle liegt, und

b2) Feststellen einer Unterspannung, wenn ein Flag vorliegt und die Spannung des Zellenverbunds unter der ersten Spannungsschwelle liegt.

Alternativ wird zur Bewertung, ob eine Über- oder eine Unterspannung vorliegt, in Schritt b) ein Spannungs- oder Strompegel eines Flags und/oder Leitungen, auf denen Flags auftreten können, überprüft.

Das erfindungsgemäße Notfallverfahren beinhaltet vorzugsweise die folgenden Schritte:

n1) Laden des Zellenverbunds mit einem Ladestrom, der geringer ist, als ein Symmetrierstrom, und

n2) Überprüfen, ob noch ein Flag besteht; ist dies nicht der Fall, Starten der Regenerierung; ist dies der Fall, Durchführen, des Schritts n2), bis die Spannung des Zellenverbunds für eine erste bestimmte Zeitspanne auf eine Maximalspannung angestiegen ist, dann Ausgeben einer Meldung über einen Defekt.

Weiter vorzugsweise beinhaltet das erfindungsgemäße Notfallverfahren den weiteren Schritt:

n3) Überprüfen, ob wenigstens eine Symmetrierschaltung für eine Zellgruppe des Zellenverbunds defekt ist, indem überprüft wird, ob der in den Zellenverbund fließende Strom um wenigstens einmal den Symmetrierstrom niedriger ist, als ein anhand eines beobachteten Spannungsanstiegs des Zellenverbunds in diesen fließender berechneter Strom, und Ausgeben einer entsprechenden Fehlermeldung, wenn dies nicht der Fall ist.

Für die Regenerierung, die erfindungsgemäß vorzugsweise mittels aktiv-bypass Symmetrierschaltungen erfolgt, werden nach dem erfindungsgemäßen Verfahren vorzugsweise die folgenden Schritte ausgeführt:

r1) Anheben der Spannung des Zellenverbunds,

r2) Überprüfen, ob die Spannung des Zellenverbunds noch nicht auf eine Maximalspannung angestiegen ist und kein Flag erscheint, ist dies nicht erfüllt, Wiederholen der Schritte r1) und r2); ist die Spannung des Zellenverbunds auf die Maximalspannung angestiegen, Beenden der Regenerierung; erscheint ein Flag, Anheben der Spannung des Zellenverbunds, bis eine höchste Spannung einer Zellgruppe bei ihrer maximalen Spannung liegt, wobei die Spannung des Zellenverbunds auf die Maximalspannung begrenzt wird, und Überprüfen, ob das Flag innerhalb einer zweiten bestimmten Zeitspanne fällt; ist dies der Fall, Wiederholen der Schritte r1) und r2); ist dies nicht der Fall, Ausgeben einer Fehlermeldung, dass ein Fehler in der Symmetrierung vorliegt.

Das erfindungsgemäße Verfahren beinhaltet vorzugsweise die Schritte:

f) Anfordern einer für die Regenerierung nötigen Energiemenge,

g) Detektieren einer Freigabe der angeforderten nötigen Energiemenge,

h) bis zum Erhalt der Freigabe, weiteres Ausführen der Schritte b), f) und g).

Bei dem erfindungsgemäßen Verfahren ist vorzugsweise die bestimmte Spannung, auf die die Spannung des Zellenverbunds im Schritt e) geregelt wird, die halbe Nennspannung (U_Nenn) des Zellenverbunds oder die halbe Spannung zwischen einer Spannung, ab der eine Unterspannung vorliegt, und einer Spannung, ab der eine Überspannung vorliegt.

Für das erfindungsgemäße Verfahren wird vorzugsweise eine zuvor dargestellte erfindungsgemäße Energiespeicher-Diagnoseschaltung verwendet.

Weitere Einzelheiten, Vorteile und Merkmale der vorliegenden Erfindung ergeben sich aus nachfolgender Beschreibung von Ausführungsbeispielen anhand der Zeichnung. Es zeigen:

Fig. 1          eine Prinzipskizze einer ersten bevorzugten Ausführungsform der erfindungsgemäßen Energiespeicher-Diagnoseschaltung,

Fig. 2　　　eine Gesamtansicht einer zweiten Ausführungsform eines Energiespeichers mit Energiespeicher-Diagnoseschaltungen, einer Schaltung für eine Temperaturmessung und einer Auswerteschaltung,

Fig. 3　　　eine zweite bevorzugte Ausführungsform der erfindungsgemäßen Energiespeicher-Diagnoseschaltung aus der in der Fig. 2 gezeigten Gesamtansicht,

Fig.4　　　eine Schaltung für die Temperaturmessung aus der in der Fig. 2 gezeigten Gesamtansicht,

Fig. 5　　　eine Auswerteschaltung aus der in der Fig. 2 gezeigten Gesamtansicht,

Fig. 6　　　eine Übersicht der für den erfindungsgemäßen Regenerierungs-Algorithmus in einer bevorzugten Ausführungsform verwendeten Spannungsschwellen,

Fig. 7a bis 7c　　ein Flussdiagramm des erfindungsgemäßen Regenerierungs-Algorithmus in einer bevorzugten Ausführungsform, und

Fig. 8　　　eine aktiv-bypass Symmetrierschaltung nach dem Stand der Technik.

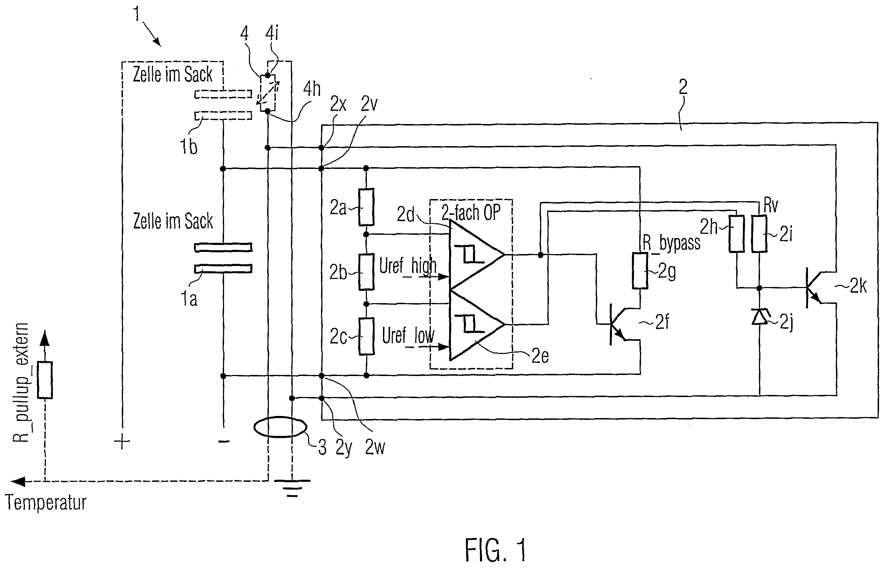

Fig. 1 zeigt eine erste bevorzugte Ausführungsform einer erfindungsgemäßen Energiespeicher-Diagnoseschaltung 2. Die Energiespeicher-Diagnoseschaltung ist hier beispielhaft nur für eine Einzelzelle 1 a eines aus zwei Einzelzellen 1 a, 1 b bestellenden Zellenverbunds 1 ausgeführt. Hierzu sind ein positiver Anschluss der Einzelzelle 1a mit einem ersten Eingang 2v der Energiespeicher-Diagnoseschaltung 2 und ein negativer Anschluss der Einzelzelle 1 a mit einem zweiten Eingang 2w der Energiespeicher-Diagnoseschaltung 2 verbunden. Weiter sind ein erster Ausgang 2x der Energiespeicher-Diagnoseschaltung 2 mit einem positiven Anschluss einer Diagnose-Rail 3 und ein zweiter Ausgang 2y der Energiespeicher-Diagnoseschaltung 2 mit einem negativen Anschluss der Diagnose-Rail 3 verbunden. Zwischen den positiven Anschluss und den negativen Anschluss der Diagnose-Rail 3 ist eine Temperaturmessschaltung 4 angeschlossen, mit deren Hilfe die Temperatur des Zellenverbunds 1 festgestellt werden kann. Die Energiespeicher-Diagnoseschaltung 2 ist der Einfachheit halber nur für eine Einzelzelle 1a des Zellenverbunds 1 gezeigt. In einer konkreten Ausführungsform ist für jede der in Reihe geschalteten Einzelzellen 1 a, 1 b des Zellverbunds 1 bzw. für aus in Reihe geschalteten Einzelzellen bestehende wiederum in Reihe geschaltete Zellgruppen des Zellenverbunds 1 eine in gleicher Weise an die Einzelzelle bzw. die Zellgruppe und die Diagnose-Rail 3 angeschlossene Energiespeicher-Diagnoseschaltung 2 vorgesehen.

Die in Fig. 1 gezeigte Energiespeicher-Diagnoseschaltung 2 in der ersten bevorzugten erfindungsgemäßen Ausführungsform umfasst zwischen ihrem ersten Eingang 2v und ihrem zweiten Eingang 2w geschaltet eine Reihenschaltung aus einem ersten Widerstand 2a, einem zweiten Widerstand 2b und einem dritten Widerstand 2c. Der Knotenpunkt zwischen dem ersten Widerstand 2a und dem zweiten Widerstand 2b ist mit einem ersten Eingang eines ersten Komparators 2d verbunden, an dessen zweitem Eingang eine hohe Referenzspannung anliegt. Der Knotenpunkt zwischen dem zweiten Widerstand 2b und dem dritten Widerstand 2c ist mit einem ersten Eingang eines zweiten Komparators 2e verbunden, an dessen zweitem Eingang eine niedrige Referenzspannung anliegt. Der erste Komparator 2d und der zweite Komparator 2e können durch einen 2-fach Operationsverstärker gebildet werden. Der Ausgang des ersten Komparators 2d ist mit der Basis eines ersten NPN-Transistors 2f verbunden, dessen Emitter mit dem zweiten Eingang 2w und dessen Kollektor über einen vierten Widerstand 2g mit dem ersten Eingang 2v der Energiespeicher-Diagnoseschaltung 2 verbunden sind. Der Ausgang des zweiten Komparators 2e ist über einen fünften Widerstand 2h mit der Basis eines zweiten NPN-Transistors 2k verbunden, dessen Emitter mit dem zweiten Ausgang 2y und dessen Kollektor mit dem ersten Ausgang 2x der Energiespeicher-Diagnoseschaltung 2 verbunden sind. An die Basis des zweiten NPN-Transistors 2k sind weiter über einen sechsten Widerstand 2i der Ausgang des ersten Komparators 2d und direkt die Kathode einer Zener-Diode 2j angeschlossen, deren Anode mit dem zweiten Ausgang 2y der Energiespeicher-Diagnoseschaltung 2 verbunden ist. Der erste NPN-Transistor 2f und der zweite NPN-Transistor 2k bilden jeweils einen gesteuerten Schalter.

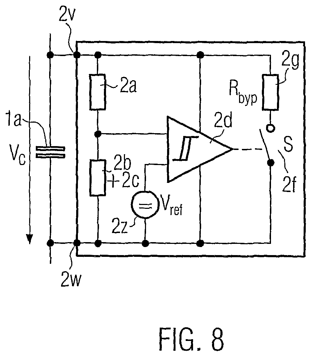

Über die Funktion der in Fig. 8 gezeigten bekannten aktiv-bypass Symmetrierschaltung hinaus, mit der ein Spannungsangleich unter den Einzelzellen bzw. Zellgruppen des Zellenverbunds herbeigeführt wird, wird durch die in Fig. 1 gezeigte Energiespeicher-Diagnoseschaltung 2 der erfindungsgemäßen ersten bevorzugten Ausführungsform die Diagnose-Rail 3 kurzgeschlossen, wenn der erste NPN-Transistor 2f für den Aktiv-Bypass durchgeschaltet wird, also wenn die hohe Referenzspannung durch die am ersten Eingang des ersten Komparators 2e anliegende Spannung überschritten wird und wenn die am ersten Eingang des zweiten Komparators 2e anliegende Spannung unter die an dessen zweitem Eingang anliegende niedrige Referenzspannung abfällt.

Wird der negative Anschluss der Diagnose-Rail 3 auf Masse gelegt und an den positiven Anschluss der Diagnose-Rail 3 ein externer Pull-Up-Widerstand geschaltet, so kann am positiven Anschluss der Diagnose-Rail 3 eine Temperaturinformation abgefragt werden, wenn die Zellspannung der Einzelzelle 1a in ihrem normalen Bereich, d.h., zwischen der niedrigen Referenzspannung und der hohen Referenzspannung, liegt, wohingegen der positive Anschluss der Diagnose-Rail 3 ebenfalls auf Masse gezogen wird, wenn die Zellspannung die niedrige Referenzspannung unterschreitet oder die hohe Referenzspannung überschreitet. Bei Überschreiten der oberen Referenzspannung durch die Zellspannung wird gleichzeitig die Symmetrierung aktiv, wodurch die Einzelzelle 1 a entladen wird bzw. ein Ladestrom an dieser vorbeifließen kann.

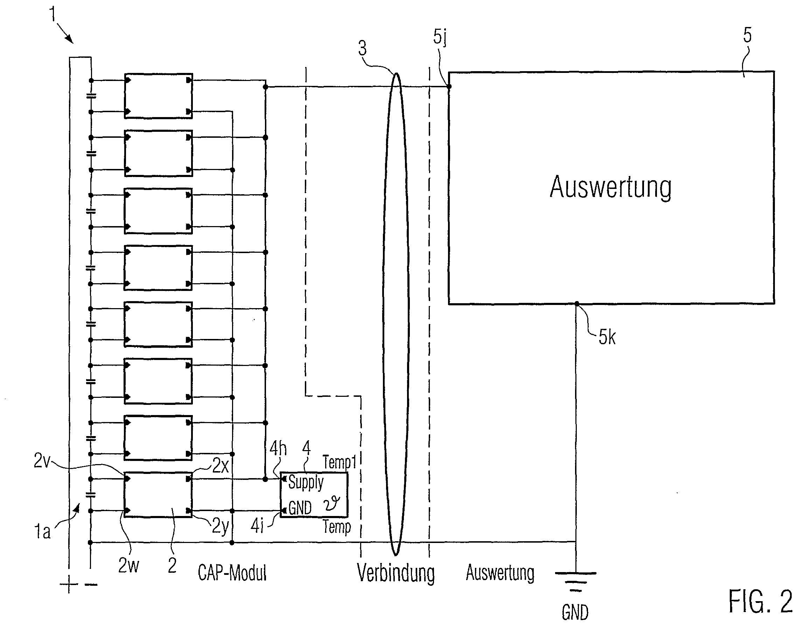

Fig. 2 zeigt den Gesamtaufbau für einen aus acht Einzelzellen bestehenden Zellenverbund 1, wobei hier, wie auch in der zuvor beschriebenen Ausführungsform, eine Einzelzelle auch aus einer Zellgruppe bestehen kann. In der Fig. 2 werden der Fig. 1 entsprechende Baugruppen durch die jeweils gleichen Bezugszeichen bezeichnet. Zusätzlich zu der Darstellung in der Fig. 1 ist hier ebenfalls eine Auswertungsschaltung 5 gezeigt, die mit einem ersten Eingang 5j an die positive Leitung der Diagnose-Rail 3 und mit einem zweiten Eingang 5k an die negative Leitung der Diagnose-Rail 3 angeschlossen ist, an der ebenfalls Masse anliegt und die weiterhin mit dem negativen Anschluss des Zellenverbunds 1 verbunden ist.

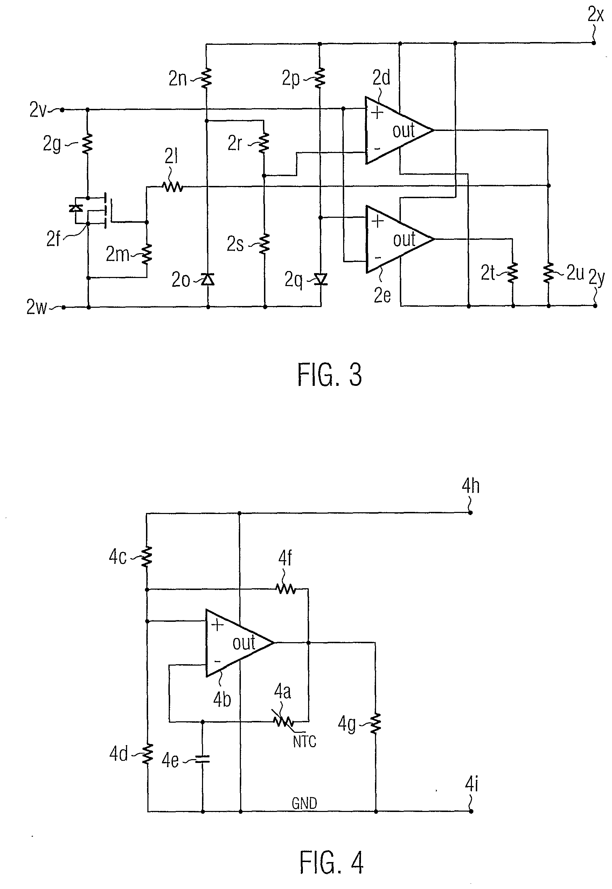

Fig. 3 zeigt eine zweite bevorzugte Ausführungsform einer erfindungsgemäßen Energiespeicher-Diagnoseschaltung 2 aus dem in Fig. 2 gezeigten Gesamtaufbau im Detail. Zu den in Fig. 1 gezeigten gleiche Bauelemente oder Bauelemente mit gleicher Funktion sind mit denselben Bezugszeichen versehen. Hier besteht der im ersten Ausführungsbeispiel aus einem NPN-Transistor bestehende Schalter 2f aus einem selbstsperrenden N-Kanal MOS-FET, dessen Drain-Source-Strecke mit dem vierten Widerstand 2g in Reihe zwischen den ersten Eingang 2v und den zweiten Eingang 2w geschaltet ist, wobei der vierte Widerstand 2g am ersten Eingang 2v angeschlossen ist und eine Diode zwischen Drain und Source des N-Kanal MOS-FETs geschaltet ist, deren Anode mit dem zweiten Eingang 2w der Energiespeicher-Diagnoseschaltung 2 und deren Kathode mit dem vierten Widerstand 2g verbunden sind. Dieser Schalter 2f wird von dem ersten Komparator 2d über einen siebten Widerstand 2l angesteuert und zwischen Gate und Source des N-Kanals MOS-FETs ist ein achter Widerstand 2m angeordnet. Der erste Eingang 2v der Energiespeicher-Diagnoseschaltung 2 ist direkt mit dem ersten (nicht-invertierenden) Eingang des ersten Komparators 2d und dem ersten (invertierenden) Eingang des zweiten Komperatos 2e verbunden. Über den ersten Ausgang 2x und den zweiten Ausgang 2y der Energiespeicher-Diagnoseschaltung 2 wird dieser eine Hilfsspannung zugeführt, die größer ist als die höchste zu erreichende Spannung des Zellenverbunds. Über einen neunten Widerstand 2n, der in Reihe mit einer ersten Diode 20 geschaltet ist, wobei die Kathode der ersten Diode 20 mit dem neunten Widerstand 2n verbunden ist und die aus neuntem Widerstand 2n und erster Diode 20 bestehende Reihenschaltung so zwischen den zweiten Eingang 2w und den ersten Ausgang 2x geschaltet ist, dass die Anode der ersten Diode 20 mit dem zweiten Eingang 2w verbunden ist, wird eine stabile Spannung erzeugt, die unabhängig von der Spannungsdifferenz zwischen dem ersten Ausgang 2x und dem zweiten Eingang 2w ist. Mit Hilfe eines aus einer Reihenschaltung eines zehnten Widerstands 2r und eines elften Widerstands 2s aufgebauten Spannungsteilers, der parallel zur ersten Diode 20 geschaltet ist, wird eine auf einem gewünschten Wert dimensionierte Referenzspannung erhalten, die am zweiten (invertierenden) Eingang des ersten Komparators 2d angelegt wird, d.h., der Knotenpunkt zwischen dem zehnten Widerstand 2r und dem elften Widerstand 2s ist mit dem zweiten Eingang des ersten Komparators 2d verbunden. Über eine Reihenschaltung, die aus einem zwölften Widerstand 2t und einer zweiten Diode 2q besteht, deren Anode mit dem zwölften Widerstand 2p verbunden ist und deren Kathode mit dem zweiten Eingang 2w verbunden ist, wobei diese Reihenschaltung zwischen den ersten Ausgang 2x und den zweiten Eingang 2w geschaltet ist, wird eine untere Referenzspannung erzeugt, die dem zweiten (nicht-invertierenden) Eingang des zweiten Komparators 2e zugeführt wird, d.h., der Knotenpunkt zwischen dem zwölften Widerstand 2p und der Anode der zweiten Diode 2q ist mit dem zweiten Eingang des zweiten Komparators 2e verbunden. Der Ausgang des zweiten Komparators 2e ist über einen dreizehnten Widerstand 2t mit dem zweiten Ausgang 2y verbunden und der Ausgang des ersten Komparators 2d ist über einen vierzehnten Widerstand 2u ebenfalls mit dem zweiten Ausgang 2y verbunden.

Durch die beschriebene Energiespeicher-Diagnoseschaltung 2 der zweiten bevorzugten Ausführungsform wird die Symmetrierung eingeschaltet, wenn die obere Referenzspannung überschritten wird, wodurch der erste Komparator 2d seinen Ausgang auf die am ersten Ausgang 2x anliegende positive Hilfsspannung schaltet, da der erste Komparator von dieser Hilfsspannung mit Spannung versorgt wird. Dadurch entsteht über den aus dem siebten Widerstand 2l und achten Widerstand 2m bestehenden Spannungsteiler eine Gate-Source-Spannung am Schalter 2f, mit der dieser durchgeschaltet wird. Mit dem Durchschalten fließt über den vierten Widerstand 2g der Symmetrierstrom, bis die obere Referenzspannung wieder unterschritten ist. Das hohe Potential am Ausgang des ersten Komparators 2d lässt einen bestimmten Strom durch den vierzehnten Widerstand 2u fließen, der sich zum Ruhestrom der Hilfsversorgung ergänzt. Dieser Stromunterschied kann von der nachfolgend beschriebenen Auswerteschaltung erkannt werden.

Wird die untere Referenzspannung unterschritten, schaltet der zweite Komparator 2e seinen Ausgang auf das hohe Potential der Hilfsversorgung, da auch der zweite Komparator 2e von der Hilfsversorgung versorgt wird. Das hohe Potential am Ausgang des zweiten Komparators 2e lässt einen bestimmten Strom durch den dreizehnten Widerstand 2t fließen, welcher sich zum Ruhestrom der Hilfsversorgung ergänzt. Die nachfolgend beschriebene Auswerteschaltung kann diesen Stromunterschied erkennen.

Fig. 4 zeigt eine Ausführungsform der in Fig. 2 gezeigten Temperaturmessschaltung 4 im Detail. Diese Schaltung ist ein temperaturabhängiger Oszillator. Ein dritter Komparator 4b, der über die mit der Diagnose-Rail 3 verbundenen Eingänge 4h, 4i der Temperaturmessschaltung 4 mit Spannung versorgt wird, ist mit seinem ersten (nicht-invertierenden) Eingang mit einer Referenzspannung verbunden, die mittels eines aus einer Reihenschaltung eines fünfzehnten Widerstands 4c und eines sechzehnten Widerstands 4d bestehenden Spannungsteiler gewonnen wird, der ebenfalls zwischen die beiden Eingänge 4h, 4i der Temperaturmessschaltung 4 geschaltet ist. Diese Referenzspannung wird über einen siebzehnten Widerstand 4f, der zwischen den Ausgang des dritten Komparators 4b und dessen ersten Eingang geschaltet ist, beeinflusst. Damit wird eine Hysterese eingestellt. Über einen zwischen dem Ausgang des dritten Komparators 4b und dessen zweiten (invertierenden) Eingang geschalteten temperaturabhängigen Widerstand 4a und einen zwischen dem zweiten Eingang des dritten Komparators 4b und dem zweiten Eingang 4i der Temperaturmessschaltung 4, d.h., Masse, geschalteten Kondensator 4e wird die Zeitkonstante des Oszillators und damit dessen Oszillatorfrequenz eingestellt. Die Änderung des temperaturabhängigen Widerstands beeinflusst so die Oszillatorfrequenz. Mit dem Schalten des dritten Komparators 4b ändert sich aufgrund eines zwischen dessen Ausgang und den zweiten Eingang 4i der Temperaturmessschaltung 4 geschalteten achtzehnten Widerstands 4g der Versorgungsstrom, wodurch die am temperaturabhängigen Widerstand bestehende Temperatur detektiert werden kann.

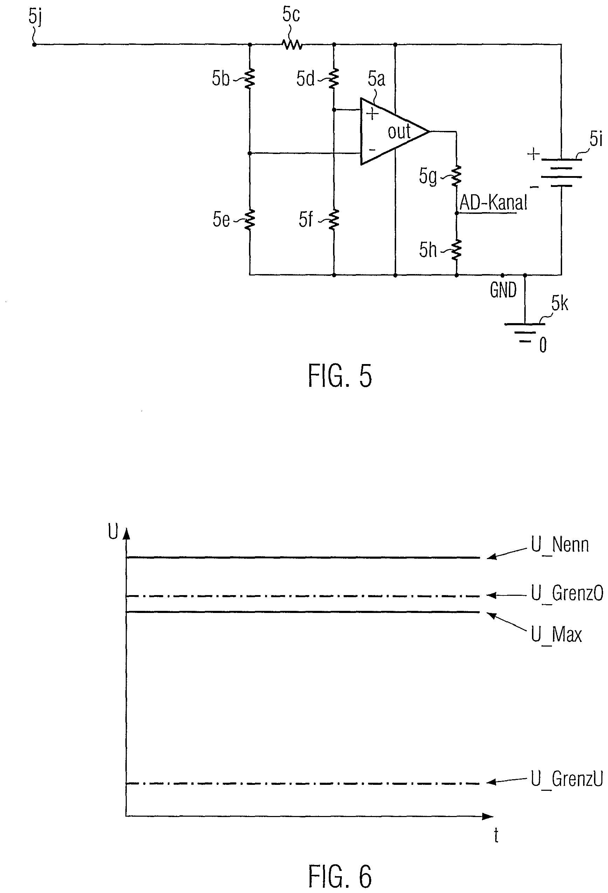

Fig. 5 zeigt die in Fig. 2 gezeigte Auswertungsschaltung 5 im Detail. Diese enthält ebenfalls die Hilfsversorgung 5i mit einer Spannung, die größer als die höchste zu erreichende Spannung des Zellenverbunds ist. Von dieser Hilfsversorgung 5i gespeist wird ein vierter Komparator 5a, zwischen dessen Ausgang und den zweiten Eingang 5k der Auswertungsschaltung 5, d.h., Masse, ein aus einer Reihenschaltung eines neunzehnten Widerstands 5g und eines zwanzigsten Widerstand 5h bestehender Spannungsteiler geschaltet ist. Über diesen kann die Höhe des an dem Knotenpunkt zwischen dem neunzehnten Widerstand 5g und dem zwanzigsten Widerstand 5h abgegriffenen Ausgangssignals der Auswertungsschaltung 5 eingestellt werden. Der erste Eingang 5j der Auswertungsschaltung 5 ist über einen einundzwanzigsten Widerstand 5c mit dem positiven Anschluss der Hilfsversorgung 5i verbunden. Zwischen dem positiven Anschluss und dem negativen Anschluss der Hilfsversorgung 5i ist weiterhin ein aus einer Reihenschaltung eines zweiundzwanzigsten Widerstands 5d und eines dreiundzwanzigsten Widerstands 5f bestehender Spannungsteiler geschaltet, dessen Knotenpunkt zwischen dem zweiundzwanzigsten Widerstand 5d und dem dreiundzwanzigsten Widerstand 5f mit dem ersten (nicht-invertierenden) Eingang des vierten Komparators 5a verbunden ist. Der erste Eingang 5j und der zweite Eingang 5k der Auswertungsschaltung 5 sind durch einen aus einer Reihenschaltung eines vierundzwanzigsten Widerstands 5b und eines fünfundzwanzigsten Widerstands 5e bestehenden Spannungsteiler verbunden, dessen Knotenpunkt zwischen dem vierundzwanzigsten Widerstand 5b und dem fünfundzwanzigsten Widerstand 5e mit dem zweiten (invertierenden) Eingang des vierten Komparators 5a verbunden ist. Das aus dem einundzwanzigsten bis fünfundzwanzigsten Widerstand bestehende Widerstandsnetzwerk ist so dimensioniert, dass der vierte Komparator 5a bei einem der Hilfsversorgung 5i entnommenen Ruhestrom der Energiespeicher-Diagnoseschaltungen 2 und der Temperaturmessschaltung 4, der einen Spannungsabfall über dem einundzwanzigsten Widerstand 5c erzeugt, gerade noch nicht schaltet. Wenn sich der Versorgungsstrom wegen des Schaltens eines Komparators in einer Energiespeicher-Diagnoseschaltung ändert, verändert sich ebenfalls der Spannungsabfall über dem einundzwanzigsten Widerstand 5c und der vierte Komparator 5a schaltet, wodurch von diesem ein bestimmter Spannungspegel auf dem Ausgang eingeprägt wird.

Im Folgenden wird eine bevorzugte Ausführungsform des erfindungsgemäßen Verfahrens zur Regenerierung eines aus in Reihe geschalteten Zellgruppen bestehenden Zellenverbunds eines Energiespeichers beschrieben. Hierzu gilt für die folgenden Variablen bzw. Konstanten:

| Flag | Wird 'wahr', sobald mindestens eine Zellspannung U_FlagO über- bzw. U_FlagU unterschreitet. |
|---|---|
| U_Stack Zellenverbunds. | Stackspannung, d.h., Spannung des |
| U_FlagO / U_FlagU | Spannungsschwellen, bei denen Flag erscheint. |
| U_Schwelle | Schwelle für Stackspannung, ab der von Überspannung ausgegangen wird. |
| U_GrenzO / U_GrenzU | Spannungsschwellen, ab denen Flags auch in symmetriertem Zustand auftreten (n - mal U_FlagO / U_FlagU). |
| U_Nenn | Nennspannung des Stacks (n - mal die Maximalspannung). |
| U_Max | Zielspannung / Abbruchkriterium, wenn U_Max erreicht wird, ohne dass ein Flag erscheint, wird von erfolgreicher Regenerierung ausgegangen. |

| | | |
|---|---|---|
| U_KritO / U_KritU | | Kritische Spannung, wenn sie erreicht wird und immer noch ein gegensätzliches Flag (z.B. Überspannung bei U_KritU) anliegt, wird von einem Fehler ausgegangen; muss kleiner / größer U_GrenzO / U_GrenzU sein. |
| U_d | | Differenzspannung; durch Anheben der Stackspannung um U_d soll die oberste Zellspannung möglichst nahe an die Maximalspannung gehoben werden. |
| t_Krit | | Zeit, die das Absenken aller oberen Zellspannungen unter U_FlagO maximal benötigen darf; sonst wird von defekter Symmetrierung ausgegangen. Bei aktiv-bypass Symmetrierungen kann dieser Wert mit dem Quotienten aus Energie in einer Zelle bei Spannungshub Maximalspannung und minimaler Symmetrierleistung berechnet werden. |

$$t\_KritByp = E\_Kond / P\_Symm$$

$$E\_Kond = \frac{1}{2} C \,[Maximalspannung-U\_FlagO]^2$$

$$P\_Symm = U\_FlagO^2 / R$$

| | | |
|---|---|---|
| | | Durch Wahl der minimalen Symmetrierleistung (untere Spannung) wurde eine konservative Auslegung gewählt, t_Krit könnte aber auch deutlich größer gewählt werden. |
| t_KritNot | | Zeit, die im Notfallalgorithmus benötigt werden darf, um bei Halten von U_Max alle Flags abzubauen; sonst Stack defekt! |
| Maximalspannung | | Nennspannung der Einzelzellen |

Die relative Lage der einzelnen Spannungsschwellen ist ebenfalls in Fig. 6 dargestellt. Hier ist zu erkennen, dass U_Nenn > U_GrenzO > U_Max > U_GrenzU ist.

Allein mit der Information, dass eine der Einzelzellen des Zellenverbunds den erlaubten Spannungsbereich verlässt, kann das erfindungsgemäße Verfahren einen Spannungsangleich unter den Einzelzellen des Zellenverbunds herbeiführen. Hierfür wird eine erfindungsgemäße Energiespeicher-Diagnoseschaltung mit aktiv-bypass Schaltung verwendet. Die durch diese Symmetrierschaltung umgesetzte Leistung entspricht $P=U^2/R$, sie steigt also quadratisch mit der Spannung. Daraus folgt, dass der Symmetriervorgang bei höheren Zellspannungen schneller abläuft. Durch den Spannungsangleich wird sichergestellt, dass die Spannungen der einzelnen Zellen möglichst identisch sind. Daraus resultiert ein maximaler nutzbarer Spannungshub des Zellenverbunds, der von der obersten bzw. untersten Zellspannung begrenzt wird.

Verlässt mindestens eine Zellspannung einer Einzelzelle den mit U_FlagO und U_FlagU begrenzten Spannungsbereich, liefert die erfindungsgemäße Energiespeicher-Diagnoseschaltung ein Flag. Das Auslösen des Flags durch extrem kurzzeitige Über- oder Unterspannungen oder Rauschen wird durch ein (nicht gezeigtes) zu dimensionierendes Zeitfilter ausgeschlossen. Ist die Spannung des Zellenverbunds U_Stack gleichzeitig oberhalb einer applizierbaren Spannungsschwelle (U_Schwelle), so wird davon ausgegangen, dass das Flag durch Überspannung ausgelöst wurde. Liegt die Spannung des Zellenverbunds U_Stack unter der applizierbaren Spannungsschwelle U-Schwelle, so wird Unterspannung angenommen. Da die Auslösespannung für das Flag unter der Maximalspannung bzw. über der Minimalspannung der Zelle liegt, würden die Zellen auch bei symmetrischer Spannungsverteilung im Zellenverbund vor Erreichen der Nennspannung, d.h., n mal die Maximalspannung, bzw. der Minimalspannung, d.h., 0 V, die Auslösespannung über- bzw. unterschreiten. Eine Unter-/Überspannung einer Einzelzelle und damit die Startbedingung für die eigentliche Regenerierung des erfindungsgemäßen Regenerierungsverfahrens liegt also nur vor, wenn die Spannung des Zellenverbunds unter bzw. über der n-fachen Auslösespannung (U_GrenzO/U_GrenzU) liegt und ein Flag erscheint, wobei n die Anzahl der Einzelzellen in dem Zellenverbund ist.

Bei aufgetretenem Flag wird zunächst ein entsprechender Merker gesetzt, der anzeigt, dass eine Über- bzw. Unterspannung aufgetreten ist. Mit diesem Merker wird gleichzeitig ein Vorhalten der für die Regenerierung nötigen Energiemenge/Batterieladung beim Energiemanagemertt angefordert. Die eigentliche Regenerierung erfolgt erst, wenn die entsprechende Freigabe aus dem Systemverbund, d.h., die Bedingung Start_Algorithmus, gegeben ist. Dies ist der Fall, sobald das System im Ruhezustand ist und genug Ladung in der Batterie zur Verfügung steht. Ohne Freigabe läuft die Überwachung der Zellspannungen weiter, auftretende Merker werden gespeichert. So werden Informationen gesammelt, wie häufig Spannungsabweichungen auftreten und ob sowohl Unter- als auch Überspannungen vorkommen.

Bei Erhalt der Freigabe wird unterschieden, ob während des Betriebs nur Unter- oder nur Überspannungen aufgetreten sind. Ist dies der Fall, wird kontrolliert, ob noch ein Flag anliegt. Wenn nicht, kann die eigentliche Regenerierung des Zellenverbunds begonnen werden.

Ist ein Flag vorhanden, so wird die Spannung des Zellenverbunds bei Überspannung abgesenkt. Fällt das Flag nicht, bevor die Spannung unter einen kritischen Wert (U_KritU) sinkt, so wird die Möglichkeit eines Defekts der das Flag auslösenden Einzelzelle oder ihrer Symmetrierungsschaltung, d.h., der erfindungsgemäße Energiespeicher-Diagnoseschaltung, in Betracht gezogen, und der später beschriebene Notfall-Algorithmus gestartet. Fällt das Flag, so kann die eigentliche Regenerierung begonnen werden.

Analog wird verfahren, wenn ausschließlich Unterspannungen aufgetreten sind. Dabei wird die Spannung angehoben, bis ein evtl. vorhandenes Flag fällt. Sollte dies nicht geschehen, bevor U_KritO erreicht wird, wird ebenfalls in den Notfall-Algorithmus gewechselt.

Kommt es während des Betriebs sowohl zu Über- als auch zu Unterspannungen, so wird die Spannung des Zellenverbunds zunächst auf eine bestimmte Spannung, beispielsweise die halbe Nennspannung geregelt. Fällt das gerade bestehende Flag dadurch ab, so kann Regenerierung gestartet werden. Bleibt auch bei mittlerer Spannung ein Flag, so steht keinerlei Information bezüglich der Art des Problems mehr zur Verfügung. Möglich sind: Unterspannung, Überspannung, Unter- und Überspannung gleichzeitig oder ein Hardware-Fehler.

Um dennoch einen Spannungsangleich herbeiführen zu können, wird ein Notfall-Algorithmus ausgeführt. Da zunächst nicht bekannt ist, ob Zellen in einem Spannungsbereich liegen, in dem ihre Symmetrierung bereits aktiv ist, und ob alle Symmetrierungen funktionieren, kann nicht einfach die Spannung des Zellenverbunds erhöht werden. Der Zellenverbund wird nun so geladen, dass der Ladestrom geringer ist, als der Symmetrierstrom. So wird sichergestellt, dass bei Zellen mit hoher Spannung, funktionierende Symmetrierung vorausgesetzt, die Spannung nicht weiter ansteigt. Zellen mit niedriger Spannung werden durch den geringen Strom geladen, ihre Spannung steigt. Sollten dadurch alle bestehenden Flags abfallen, wird in den normalen eigentlichen Regenerierungs-Algorithmus gewechselt.

Steigt die Spannung bis U_Max (Abbruchbedingung der eigentlichen Regenerierung) und wenigstens ein Flag bleibt gesetzt, so wird sie konstant auf U_Max gehalten. Fällt das Flag nicht innerhalb von T_KritNot, so liegt ein Defekt des Zellenverbunds vor und eine entsprechende Meldung wird ausgegeben.

Eine defekte Symmetrierung kann erkannt werden, indem die Steigerung des Spannungsanstiegs beobachtet wird. Mit $I = C \cdot dU/dt$ lässt sich der in dem Zellenverbund fließende Strom berechnen. Bei der Voraussetzung, dass bei der Spannung des Zellenverbunds von U_Nenn/2 keine Zelle umgepolt ist, d.h., die niedrigste Zellspannung mindestens 0 V ist, sollte bei Erhöhung der Spannung um $n \cdot$ U_FlagU+Sicherheitsabstand kein Unterspannungsflag mehr anliegen. Daraus folgt, dass mindestens eine Zelle Überspannung haben muss und deshalb mindestens eine Symmetrierung aktiv sein muss. Also sollte der berechnete Strom, der den Zellenverbund lädt, um mindestens einmal den Symmetrierstrom niedriger sein, als der in dem Zellenverbund fließende Strom. Ist dies nicht der Fall, muss davon ausgegangen werden, dass mindestens eine Symmetrierung defekt ist.

Vor Beginn des eigentlichen Algorithmus zur Regenerierung wurde somit sichergestellt, dass keine Zellspannung über U_FlagO liegt. Nun kann die Spannung angehoben werden, ohne Gefahr zu laufen, eine der Einzelzellen zu beschädigen.

Wird die festzulegende Zielspannung U_Max mit der Spannung des Zellenverbunds erreicht, bevor ein Flag erscheint, ist keine weitere Regenerierung des Zellenverbunds nötig. Die Abbruchbedingung der eigentlichen Regenerierung ist erfüllt. Die Zielspannung hängt von der zu erreichenden maximalen Spannung des Zellenverbunds ab, sie kann aber maximal U_GrenzO entsprechen, da darüber Flags erscheinen müssen.

Erscheint ein Flag, so wird die Spannung des Zellenverbunds soweit angehoben, dass die höchste Zellspannung möglichst nah an der Maximalspannung liegt, da der Spannungsangleich, wie erwähnt, bei höherer Spannung schneller erfolgt. Um dies zu erreichen, wird eine dafür nötige Differenzspannung U_d festgelegt. Theoretisch entspricht sie n mal der Differenz zwischen Auslösespannung (U_FlagO) und Maximalspannung der Zelle, tatsächlich müssen aus Gründen der Toleranzbetrachtung noch Mess- und Bauteilgenauigkeiten betrachtet werden, um einen gewissen Sicherheitsabstand zu haben und so ein Überschreiten der Maximalspannung auszuschließen. Das Anheben der Spannung wird auf U_Nenn begrenzt. Fällt das Flag aufgrund der Symmetrierung, wird ein weiterer Durchlauf des Algorithmus zur eigentlichen Regenerierung gestartet, bis U_Max erreicht wird. Sollte das Flag nicht innerhalb von T_Krit fallen, liegt ein Fehler der Symmetrierung vor, die eigentliche Regenerierung wird abgebrochen und eine entsprechende Fehlermeldung wird ausgegeben.

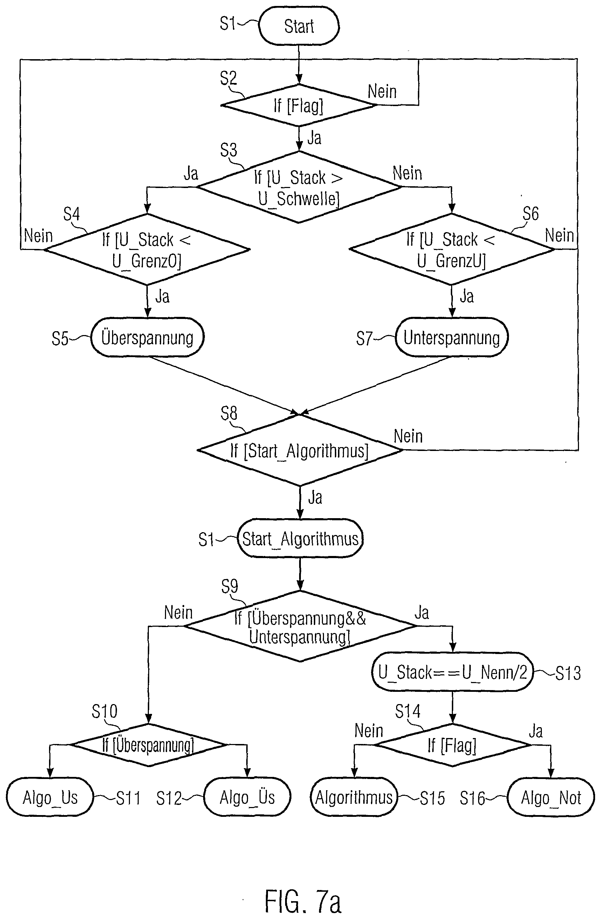

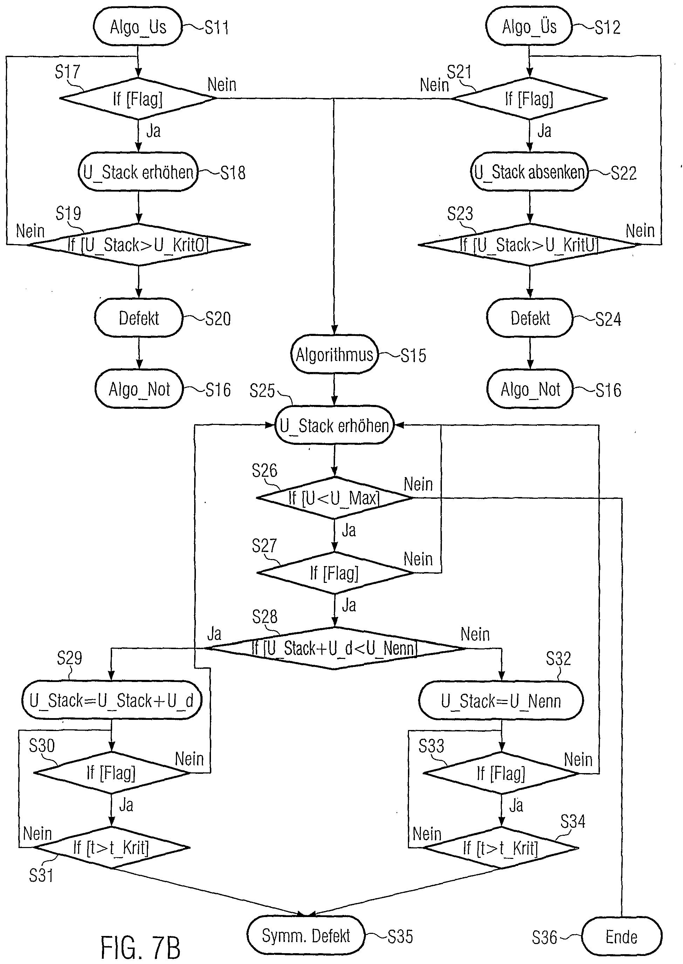

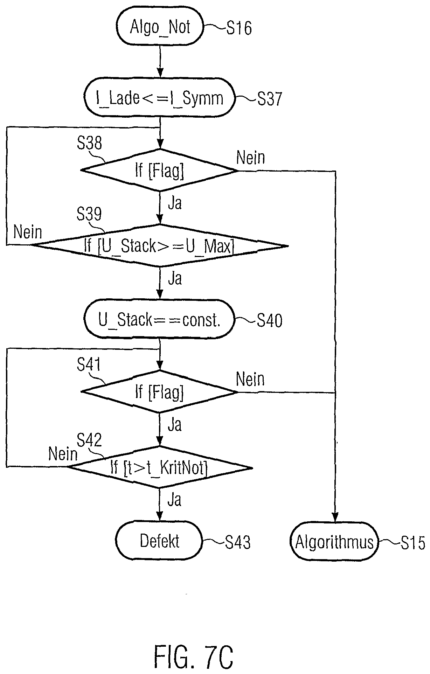

Fig. 7a bis 7c zeigen dieselbe bevorzugte Ausführungsform des erfindungsgemäßen Verfahrens im Flussdiagramm. Nachdem das Verfahren in einem ersten Schritt S1 gestartet wurde, wird in einem zweiten Schritt S2 überprüft, ob ein Flag vorliegt. Ist dies nicht der Fall, so wird der zweite Schritt S2 erneut ausgeführt. Liegt im zweiten Schritt S2 ein Flag vor, so wird in einem dritten Schritt S3 überprüft, ob die Spannung des Zellenverbunds über der Schwelle für die Spannung des Zellenverbunds liegt, ab der von einer Überspannung ausgegangen wird. Ist dies der Fall, so wird in einem vierten Schritt S4 überprüft, ob die Spannung des Zellenverbunds kleiner ist, als eine obere Spannungsschwelle, ab der ein Flag auch in dem symmetrierten Zustand auftritt. Ist dies nicht der Fall, so wird erneut zum zweiten Schritt S2 verzweigt. Ist dies der Fall, so wird in einem fünften Schritt S5 ein Merker gespeichert, dass eine Überspannung vorliegt. Wird im dritten Schritt S3 jedoch bestimmt, dass die Spannung des Zellenverbunds nicht oberhalb der Schwelle für die Spannung des Zellverbunds liegt, ab der von einer Überspannung ausgegangen wird, so wird ein sechster Schritt S6 ausgeführt, in dem überprüft wird, ob die Spannung des Zellenverbunds größer ist, als eine untere Spannungsschwelle, ab der ein Flag auch in symmetriertem Zustand auftritt. Ist dies nicht der Fall, so wird erneut in den zweiten Schritt S2 verzweigt. Ist dies der Fall, so wird ein siebter Schritt S7 ausgeführt, in dem ein Merker gespeichert wird, dass eine Unterspannung vorliegt. Nach dem fünften Schritt S5 bzw. dem siebten Schritt S7 wird in einem achten Schritt S8 geprüft, ob eine Freigabe der eigentlichen Regenerierung aus dem Systemverbund besteht. Ist dies nicht der Fall, so wird erneut in den zweiten Schritt S2 verzweigt. Ist dies der Fall, so wird in einem neunten Schritt S9 geprüft, ob Überspannungen und Unterspannungen vorliegen. Ist dies nicht der Fall, d.h., es liegen nur Überspannungen oder nur Unterspannungen vor, so wird in einem zehnten Schritt S10 geprüft, ob nur Überspannungen vorliegen. Ist dies nicht der Fall, so wird in einem elften Schritt S11 ein Algorithmus für Unterspannungen gestartet. Ist dies der Fall, so wird in einem zwölften Schritt S12 ein Algorithmus für Überspannungen gestartet. Werden im neunten Schritt S9 jedoch Überspannungen und Unterspannungen festgestellt, so wird in einem dreizehnten Schritt S13 die Spannung des Zellenverbunds auf die halbe Nennspannung geregelt. Anschließend wird in einem vierzehnten Schritt S14 überprüft, ob noch ein Flag vorliegt. Ist dies nicht der Fall, so wird der normale Regenerierungs-Algorithmus in einem fünfzehnten Schritt S15 gestartet. Ist dies der Fall, so wird in einem sechzehnten Schritt S16 der oben beschriebene und in Fig. 7c dargestellte Notfall-Algorithmus ausgeführt.

Wird im elften Schritt S11 der Algorithmus für Unterspannung gestartet, so wird anschließend in einem siebzehnten Schritt S17 überprüft, ob noch ein Flag anliegt. Ist dies nicht der Fall, so wird in den fünfzehnten Schritt S15 verzweigt, in dem der eigentliche Regenerierungs-Algorithmus gestartet wird. Ist dies der Fall, so wird in einem achtzehnten Schritt S18 die Spannung des Zellenverbunds erhöht. Anschließend wird in einem neunzehnten Schritt S19 abgefragt, ob die Spannung des Zellenverbunds größer ist als eine kritische obere Spannung, bei der, wenn immer noch ein gegensätzliches Flag anliegt, hier also ein Flag für eine Unterspannung, von einem Fehler ausgegangen werden muss. Ist dies der Fall, so wird in einem folgenden zwanzigsten Schritt S20 ein Defekt angezeigt und danach in den sechzehnten Schritt S16 verzweigt, in dem der Notfall-Algorithmus gestartet wird. Wird im neunzehnten Schritt S19 nicht festgestellt, dass die Spannung des Zellenverbunds größer als die obere kritische Spannung ist, so wird in den siebzehnten Schritt S17 verzweigt.

Wird im zwölften Schritt S12 der Algorithmus für Überspannung gestartet, so wird in einem nachfolgenden einundzwanzigsten Schritt S21 überprüft, ob noch ein Flag anliegt. Ist dies nicht der Fall, so wird in den fünfzehnten Schritt S15 verzweigt, in dem der eigentliche Regenerierungs-Algorithmus gestartet wird. Ist dies nicht der Fall, so wird in einem zweiundzwanzigsten Schritt S22 die Spannung des Zellenverbunds abgesenkt, wonach in einem dreiundzwanzigsten Schritt S23 überprüft wird, ob die Spannung des Zellenverbunds kleiner als eine untere kritische Spannung ist, bei deren Unterschreiten bei Vorliegen eines gegensätzlichen Flags, d.h., eines Flags für Überspannung, von einem Fehler ausgegangen werden muss. Ist dies der Fall, so wird in einem vierundzwanzigsten Schritt S24 ein Defekt angezeigt, bevor in den sechzehnten Schritt S16 verzweigt wird, in dem der Notfall-Algorithmus gestartet wird. Wird im dreiundzwanzigsten Schritt S23 nicht festgestellt, dass die Spannung des Zellenverbunds kleiner als die untere kritische Spannung ist, so wird erneut in den einundzwanzigsten Schritt S21 verzweigt.

Wird im fünfzehnten Schritt S15 der eigentliche Regenerierungs-Algorithmus, d.h., eine Regenerierung des Zellenverbunds gestartet, so wird in einem nachfolgenden fünfundzwanzigsten Schritt S25 die Spannung des Zellenverbunds erhöht. Danach wird in einem sechsundzwanzigsten Schritt S26 überprüft, ob die Spannung des Zellenverbunds kleiner als die Zielspannung ist. Ist dies nicht der Fall, so wird erneut der fünfundzwanzigste Schritt S25 ausgeführt. Ist dies der Fall, so wird in einem siebenundzwanzigsten Schritt S27 überprüft, ob ein Flag vorliegt. Ist dies nicht der Fall, so wird erneut in den fünfundzwanzigsten Schritt S25 verzweigt. Ist dies der Fall, so wird in einem achtundzwanzigsten Schritt S28 überprüft, ob die Spannung des Zellenverbunds plus der Differenzspannung kleiner als die Nennspannung ist. Ist dies der Fall, so wird in einem neunundzwanzigsten Schritt S29 die Spannung des Zellenverbunds gleich der Spannung des Zellenverbunds plus der Differenzspannung gesetzt. Danach wird in einem dreißigsten Schritt S30 überprüft, ob ein Flag vorliegt. Ist dies nicht der Fall, so wird erneut in den fünfundzwanzigsten Schritt S25 verzweigt. Ist dies der Fall, so wird in einem einunddreißigsten Schritt überprüft, ob eine seit der Ausführung des neunundzwanzigsten Schritts S29 laufende Zeit größer als eine Zeit ist, die das Absenken aller oberen Zellspannungen unter U_FlagO Maximal benötigen darf, bevor von einer defekten Symmetrierung ausgegangen werden muss. Ist dies nicht der Fall, so wird erneut in den dreißigsten Schritt S30 verzweigt. Ist dies der Fall, so wird in einem fünfunddreißigsten Schritt S35 angezeigt, dass eine Symmetrierung defekt ist. Wird im achtundzwanzigsten Schritt S28 festgestellt, dass die Spannung des Zellenverbunds plus der Differenzspannung nicht kleiner als die Nennspannung ist, so wird in einem zweiunddreißigsten Schritt S32 die Spannung des Zellenverbunds gleich der Nennspannung gesetzt. Danach wird in einem dreiunddreißigsten Schritt S33 überprüft, ob ein Flag vorliegt. Ist dies nicht der Fall, so wird erneut der 25ste Schritt S25 ausgeführt. Ist dies der Fall, so wird in einem vierunddreißigsten Schritt S34 überprüft, ob eine seit der Ausführung des zweiunddreißigsten Schritts S32 laufende Zeit größer als die Zeit ist, die das Absenken aller oberen Zellspannungen unter U_FlagO Maximal benötigen darf, bevor von einer defekten Symmetrierung ausgegangen wird. Ist dies nicht der Fall, so wird erneut in den dreiunddreißigsten Schritt S33 verzweigt. Ist dies der Fall, so wird der zuvor schon beschriebene fünfunddreißigsten Schritt S35 ausgeführt.

Wird im sechsundzwanzigsten Schritt S26 festgestellt, dass die Spannung des Zellenverbunds nicht kleiner als die Zielspannung ist, so wird die eigentliche Regenerierung in einem sechsunddreißigsten Schritt S36 beendet. Danach wird das erfindungsgemäße Regenerierungsverfahren, beginnend beim ersten Schritt S1, erneut ausgeführt.

Wird im sechzehnten Schritt S16 der Notfall-Algorithmus gestartet, so wird in einem nachfolgenden siebenunddreißigsten Schritt S37 der Ladestrom I_Lade kleiner gleich dem Symmetrierstrom I_Symm gesetzt. Danach wird in einem achtunddreißigsten Schritt S38 überprüft, ob noch ein Flag vorliegt. Ist dies nicht der Fall, so wird der eigentliche Algorithmus zur Regenerierung gestartet, d.h., in den fünfzehnten Schritt S15 verzweigt. Liegt im achtunddreißigsten Schritt S38 ein Flag vor, so wird in einem neununddreißigsten Schritt S39 geprüft, ob die Stackspannung U_Stack größer gleich der Zielspannung U_Max ist. Ist dies nicht der Fall, so wird erneut der achtunddreißigste Schritt S38 ausgeführt. Ist dies der Fall, so wird ein vierzigster Schritt S40 ausgeführt, in dem die Stackspannung konstant gehalten wird. Danach wird in einem einundvierzigsten Schritt S41 überprüft, ob ein Flag vorliegt. Ist dies nicht der Fall, so wird der eigentliche Algorithmus zur Regenerierung gestartet, d.h., in den fünfzehnten Schritt S15 verzweigt. Liegt im einundvierzigsten Schritt S41 jedoch ein Flag vor, so wird ein zweiundvierzigster Schritt S42 ausgeführt, in dem überprüft wird, ob seit dem Auftreten des Flags im einundvierzigsten Schritt S41 eine kritische Zeit des Notfallalgorithmus t_KritNot verstrichen ist. Ist dies nicht der Fall, so wird erneut der einundvierzigste Schritt S41 ausgeführt. Ist dies der Fall, so liegt ein Defekt des Zellenverbunds vor und in einem nachfolgenden Schritt S43 wird eine Meldung ausgegeben, dass ein Defekt vorliegt.

Bei einer Energiespeicher-Diagnoseschaltung für eine Zellgruppe in einem Zellverbund eines Energiespeichers, insbesondere eines Energiespeichers in einem Kraftfahrzeug-Bordnetz, wobei die Energiespeicher-Diagnoseschaltung mit Spannungsanschlüssen der Zellgruppe verbunden ist, wird also ein bestimmter Spannungspegel und/oder Strom auf eine Diagnose-Rail eingeprägt, über die wenigstens ein überwachter Betriebsparameter der Zellgruppe und/oder des Zellenverbunds abgefragt werden kann, wenn eine an den Spannungsanschlüssen der Zellgruppe anliegende Zellgruppenspannung einen ersten Schwellenpegel überschreitet und/oder wenn die Zellgruppenspannung einen zweiten Schwellenpegel unterschreitet. Auf Grundlage von solchen Flags wird dann ein Regenerierungsverfahren ausgeführt, bei dem unterschieden wird, ob ein Defekt vorliegt oder nicht.

## Patentansprüche

1. Verfahren zur Regenerierung eines aus in Reihe geschalteten Zellgruppen (1 a) bestehenden Zellenverbunds (1) eines Energiespeichers mittels Energiespeicher-Diagnoseschaltungen (2), die an die Zellgruppen (1 a) angeschlossen sind, wobei jede Energiespeicher-Diagnoseschaltung (2) bei Vorliegen einer Überspannung oder einer Unterspannung der daran angeschlossenen Zellgruppe (1 a) ein Flag ausgibt, mit den folgenden Schritten:

   a) Detektieren des Vorliegens wenigstens eines Flags (S2),
   b) Bewerten, ob eine Über- oder eine Unterspannung vorliegt (S3) und Setzen eines Merkers (S5, S7) über das Vorliegen einer Über- oder Unterspannung, und
   c) Überprüfen, ob nur Überspannungen oder nur Unterspannungen aufgetreten sind (S9), **gekennzeichnet durch** die Schritte:
   d) liegen nur Überspannungen oder nur Unterspannungen vor, Überprüfen, ob noch ein Flag anliegt (S17, S21); wenn gerade kein Flag anliegt, Starten einer Regenerierung (S15); wenn gerade ein Flag anliegt, Überprüfen, ob ein Defekt vorliegt (S19, S23), Starten einer Regenerierung (S15) bei keinem Defekt und Starten eines Notfallverfahrens (S16) bei einem Defekt, und
   e) liegen Überspannungen und Unterspannungen vor, Regeln der Spannung des Zellenverbunds (U_Stack) auf eine bestimmte Spannung (S13), Überprüfen, ob noch ein Flag anliegt (S14); wenn gerade kein Flag anliegt, Starten einer Regenerierung (S15); wenn gerade ein Flag anliegt, Starten eines Notfallverfahrens (S16).

2. Verfahren nach Anspruch 1, **gekennzeichnet durch** die folgenden Schritte zum Überprüfen, ob ein Defekt vorliegt im Schritt d):

d1) bei ausschließlichem Vorliegen von Überspannungen, Absenken der Spannung des Zellenverbunds (U_Stack) (S22) und Überprüfen, ob das gerade anliegende Flag fällt (S21), bevor die Spannung des Zellenverbunds (U_Stack) unter einen ersten kritischen Wert (U_KritU) gefallen ist; ist dies der Fall, liegt kein Defekt vor, ist dies nicht der Fall, liegt ein Defekt (S24) vor, und

d2) bei ausschließlichem Vorliegen von Unterspannungen, Anheben der Spannung des Zellenverbunds (U_Stack) (S18) und Überprüfen, ob das gerade anliegende Flag fällt (S17), bevor die Spannung des Zellenverbunds (U_Stack) über einen zweiten kritischen Wert (U_KritO) gestiegen ist; ist dies der Fall, liegt kein Defekt vor, ist dies nicht der Fall, liegt ein Defekt (S20) vor.

3. Verfahren nach Anspruch 1 oder 2, **gekennzeichnet durch** die folgenden Schritte zum Bewerten, ob eine Über- oder eine Unterspannung vorliegt, im Schritt b):

b1) Feststellen einer Überspannung, wenn ein Flag vorliegt (S2) und die Spannung des Zellenverbunds (U_Stack) über einer ersten Spannungsschwelle (U_Schwelle) liegt (S3), und

b2) Feststellen einer Unterspannung, wenn ein Flag vorliegt (S2) und die Spannung des Zellenverbunds (U_Stack) unter der ersten Spannungsschwelle (U_Schwelle) liegt (S3).

4. Verfahren nach Anspruch 1 oder 2, **dadurch gekennzeichnet, dass** zur Bewertung, ob eine Über- oder eine Unterspannung vorliegt, in Schritt b) ein Spannungs- oder Strompegel eines Flags und/oder Leitungen, auf denen Flags auftreten können, überprüft werden.

5. Verfahren nach einem der Ansprüche 1 bis 4, **gekennzeichnet durch** die folgenden Schritte für das Notfallverfahren:

n1) Laden des Zellenverbunds (1) mit einem Ladestrom, der geringer ist, als ein Symmetrierstrom (S37), und

n2) Überprüfen, ob noch ein Flag besteht (S38); ist dies nicht der Fall, Starten der Regenerierung (S15); ist dies der Fall, Durchführen, des Schritts n2), bis die Spannung des Zellenverbunds (U_Stack) für eine erste bestimmte Zeitspanne auf eine Maximalspannung angestiegen ist (S39 bis S42), dann Ausgeben einer Meldung über einen Defekt (S43).

6. Verfahren nach Anspruch 5, **gekennzeichnet durch** den folgenden weiteren Schritt für das Notfallverfahren:

n3) Überprüfen, ob wenigstens eine Symmetrierschaltung für eine Zellgruppe des Zellenverbunds defekt ist, indem überprüft wird, ob der in den Zellenverbund fließende Strom um wenigstens einmal den Symmetrierstrom niedriger ist, als ein anhand eines beobachteten Spannungsanstiegs des Zellenverbunds in diesen fließender berechneter Strom, und Ausgeben einer entsprechenden Fehlermeldung, wenn dies nicht der Fall ist.

7. Verfahren nach einem der Ansprüche 1 bis 6, **gekennzeichnet durch** die folgenden Schritte für die Regenerierung:

r1) Anheben der Spannung des Zellenverbunds (S25), und

r2) Überprüfen, ob die Spannung des Zellenverbunds (U_Stack) noch nicht auf eine Maximalspannung (U_Max) angestiegen ist (S26) und kein Flag erscheint (S27), ist dies nicht erfüllt, Wiederholen der Schritte r1) und r2); ist die Spannung des Zellenverbunds auf die Maximalspannung (U_Max) angestiegen, Beenden der Regenerierung (S36); erscheint ein Flag, Anheben der Spannung des Zellenverbunds (U_Stack), bis eine höchste Spannung einer Zellgruppe bei ihrer maximalen Spannung liegt, wobei die Spannung des Zellenverbunds (U_Stack) auf die Nennspannung (U_Nenn) begrenzt wird (S25, S29, S32), und Überprüfen, ob das Flag innerhalb einer zweiten bestimmten Zeitspanne (T_Krit) (S31, S34) fällt; ist dies der Fall, Wiederholen der Schritte r1) und r2); ist dies nicht der Fall, Ausgeben einer Fehlermeldung (S35), dass ein Fehler in der Symmetrierung vorliegt.

8. Verfahren nach einem der Ansprüche 1 bis 7, **gekennzeichnet durch** die Schritte:

f) Anfordern einer für die Regenerierung nötigen Energiemenge,

g) Detektieren einer Freigabe der angeforderten nötigen Energiemenge, und

h) bis zum Erhalt der Freigabe, weiteres Ausführen der Schritte b), f) und g), vor dem Schritt c), wobei der Schritt c) dann erst nach Erhalt der Freigabe ausgeführt wird.

9. Verfahren nach einem der Ansprüche 1 bis 8, **dadurch gekennzeichnet, dass** die bestimmte Spannung, auf die die Spannung des Zellenverbunds im Schritt e) geregelt wird, die halbe Nennspannung (U_Nenn) des Zellenverbunds oder die halbe Spannung zwischen einer Spannung, ab der eine Unterspannung vorliegt, und einer Spannung, ab der eine Überspannung vorliegt, ist.

**Claims**

1. A method for regenerating a cell composite (1) of an energy storage element, which cell composite comprises cell groups (1a) connected in series, by means of energy storage element diagnostic circuits (2), which are connected to the cell groups (1a), wherein each energy storage element diagnostic circuit (2) outputs a flag in the presence of an overvoltage or an undervoltage of the cell group (1a) connected to said circuit, said method comprising the following steps:

   a) detecting the presence of at least one flag (S2),
   b) assessing whether an overvoltage or an undervoltage is present (S3) and setting a flag (S5, S7) relating to the presence of an overvoltage or undervoltage, and
   c) checking whether only overvoltages or only undervoltages have occurred (S9),

   **characterised by** the following steps:

   d) if only overvoltages or only undervoltages are present, checking whether a flag is still present (S17, S21); if there is now no flag present, starting a regeneration (S15); if there is a flag still present, checking whether a defect is present (S19, S23), starting a regeneration (S15) if there is no defect, and starting an emergency procedure (S16) if there is a defect, and
   e) if overvoltages and undervoltages are present, controlling the voltage of the cell composite (U_Stack) to a specific voltage (S13), checking whether a flag is still present (S14); if there is now no flag present, starting a regeneration (S15); if there is still a flag present, starting an emergency procedure (S16).

2. A method according to claim 1, **characterised by** the following steps for checking whether a defect is present in step d):

   d1) with the presence exclusively of overvoltages, reducing the voltage of the cell composite (U_Stack) (S22) and checking whether the currently present flag disappears (S21) before the voltage of the cell composite (U_Stack) has dropped below a first critical value (U_KritU); if this is the case, there is no defect present, if this is not the case, there is a defect present (S24), and
   d2) with the presence exclusively of undervoltages, increasing the voltage of the cell composite (U_Stack) (S18) and checking whether the currently present flag disappears (S17) before the voltage of the cell composite (U_Stack) has risen above a second critical value (U_KritO); if this is the case, there is no defect present, if this is not the case, there is a defect present (S20).

3. A method according to claim 1 or 2, **characterised by** the following steps for assessing whether there is an overvoltage or an undervoltage present, in step b):

   b1) determining an overvoltage if a flag is present (S2) and the voltage of the cell composite (U_Stack) lies above a first voltage threshold (U_Schwelle) (S3), and
   b2) determining an undervoltage if a flag is present (S2) and the voltage of the cell composite (U_Stack) lies below the first voltage threshold (U_Schwelle) (S3).

4. A method according to claim 1 or 2, **characterised in that,** in order to assess whether an overvoltage or an undervoltage is present, a voltage level or current level of a flag and/or cables over which flags can occur is checked in step b).

5. A method according to any one of claims 1 to 4, **characterised by** the following steps for the emergency procedure:

   n1) charging the cell composite (1) with a charging current, which is lower than a balancing current (S37), and
   n2) checking whether a flag still exists (S38); if this is not the case, starting the regeneration (S15); if this is the case, carrying out step n2) until the voltage of the cell composite (U_Stack) has risen to a maximum voltage for a first specific period of time (S39 to S42), then outputting a message relating to a defect (S43).

**6.** A method according to claim 5, **characterised by** the following further step for the emergency procedure:

n3) checking whether at least one balancing circuit for a cell group of the cell composite is defective by checking whether the current flowing into the cell composite is lower by at least one times the balancing current than a current flowing into the cell composite calculated on the basis of an observed voltage rise of the cell composite, and outputting a corresponding error message if this is not the case.

**7.** A method according to any one of claims 1 to 6, **characterised by** the following steps for the regeneration:

r1) increasing the voltage of the cell composite (S25) and
r2) checking whether the voltage of the cell composite (U_Stack) has yet risen to a maximum voltage (U_Max) (S26), and if no flag has appeared (S27) this condition has not been met, repeating the steps r1) and r2); if the voltage of the cell composite has risen to the maximum voltage (U_Max), ending the regeneration (S36); if a flag appears, increasing the voltage of the cell composite (U_Stack) until a highest voltage of a cell group lies at the maximum voltage thereof, wherein the voltage of the cell composite (U_Stack) is limited to the rated voltage (U_Nenn) (S25, S29, S32), and checking whether the flag disappears within a second specific time period (T_Krit) (S31, S34); if this is the case, repeating steps r1) and r2); if this is not the case, outputting an error message (S35) informing that an error is present in the balancing.

**8.** A method according to any one of claims 1 to 7, **characterised by** the following steps:

f) requesting a quantity of energy necessary for the regeneration,
g) detecting a release of the required necessary quantity of energy, and
h) until the release has been received, continuing to carry out steps b), f) and g), before step c), wherein step c) is carried out only once the release has been received.

**9.** A method according to any one of claims 1 to 8, **characterised in that** the specific voltage to which the voltage of the cell composite is controlled in step e) is half the rated voltage (U_Nenn) of the cell composite or half the voltage between a voltage from which an undervoltage is present and a voltage from which an overvoltage is present.

**Revendications**

**1.** Procédé permettant de régénérer un ensemble de cellules (1) d'un accumulateur d'énergie constitué par des groupes de cellules (1a) montés en série, au moyen de circuits de diagnostic d'accumulateurs d'énergie (2) qui sont branchés sur les groupes de cellules (1a), chaque circuit de diagnostic d'accumulateur d'énergie (2) délivrant un signal avertisseur, en présence d'une surtension ou d'une sous-tension du groupe de cellules (1a), sur lequel il est branché, comprenant les étapes suivantes consistant à :

a) détecter la présence d'au moins un signal avertisseur (S2),
b) déterminer si il y a une surtension ou une sous-tension (S3) et activer (S5, S7) un indicateur de la présence d'une surtension ou d'une sous-tension, et
c) vérifier si il n'y a que des surtensions ou que des sous-tensions qui sont présentes (S9),

**caractérisé par** les étapes suivantes :

d) s'il n'y a que des surtensions ou que des sous-tensions, vérifier s'il y a encore un signal avertisseur (S17, S21), lorsqu'il n'y a pas de signal avertisseur, commencer une régénération (S15) lorsqu'il y a un signal avertisseur, vérifier s'il y a un défaut (S19, S23), commencer une régénération (S15) dans le cas où il n'y a pas de défaut et commencer un procédé d'urgence (S 16) dans le cas où il y a un défaut, et
e) s'il y a des surtensions et des sous-tensions, régler la tension de l'ensemble de cellules (U_Stack) à une tension définie (S13), vérifier s'il y a encore un signal avertisseur (S14), s'il n'y a pas de signal avertisseur, commencer une régénération (S15), s'il y a un signal avertisseur commencer un procédé d'urgence (S 16).

**2.** Procédé conforme à la revendication 1,
**caractérisé par**,
les étapes suivantes permettant de vérifier s'il y a un défaut lors de l'étape d) consistant à :

d1) s'il y a que des surtensions, diminuer la tension de l'ensemble de cellules (U_Stack) (S22) et vérifier si le signal avertisseur délivré chute (S21), avant que la tension de l'ensemble de cellules (U_Stack) ait chuté au-dessous d'une première valeur critique (U_KritU), si tel est le cas, il n'y a pas de défaut, si tel n'est pas le cas, il y a un défaut (S24), et

d2) s'il n'y a que des sous-tensions, augmenter la tension de l'ensemble de cellules (U_Stack) (S 18) et vérifier si le signal avertisseur délivré chute (S17), avant que la tension de l'ensemble de cellules (U_Stack) ait augmenté au-dessus d'une seconde valeur critique (U_KritO), si tel est le cas, il n'y a aucun défaut, si tel n'est pas le cas, il y a un défaut (S20).

3. Procédé conforme à la revendication 1 ou 2,
   **caractérisé par**,
   les étapes suivantes permettant d'évaluer s'il y a une surtension ou une sous-tension lors de l'étape b) consistant à :

   b1) déterminer une surtension lorsqu'il y a un signal avertisseur (S2) et que la tension de l'ensemble de cellules (U_Stack) est située au-dessus d'un premier seuil de tension (U_Schwelle) (S3), et
   b2) déterminer la présence d'une sous-tension lorsqu'il y a un signal avertisseur (S2) et que la tension de l'ensemble de cellules (U_Stack) est située au-dessous du premier seuil de tension (U_Schelle) (S3).

4. Procédé conforme à la revendication 1 ou 2,
   **caractérisé en ce que**,
   pour évaluer s'il y a une surtension ou une sous-tension, lors de l'étape b), on vérifie un pic de tension ou un pic de courant d'un signal avertisseur et/ou de conduites sur lesquelles des signaux avertisseurs peuvent apparaître.

5. Procédé conforme à l'une des revendication 1 à 4,
   **caractérisé par**,
   les étapes suivantes du procédé d'urgence consistant à :

   n1) charger l'ensemble de cellules (1) avec un courant de charge qui est inférieur à un courant d'équilibrage (S37), et
   n2) vérifier s'il y a encore un signal avertisseur (S38), si tel n'est pas le cas, commencer la régénération (S15), si tel est le cas, mettre en oeuvre l'étape n2) jusqu'à ce que la tension de l'ensemble de cellules (U_Stack) ait pendant une première durée déterminée, augmenté à une tension maximum (S39 à S42) puis délivrer un message de défaut (S43).

6. Procédé conforme à la revendication 5,
   **caractérisé par**
   les étapes suivantes du procédé d'urgence consistant à :

   n3) vérifier si au moins un circuit d'équilibrage d'un groupe de cellules de l'ensemble de cellules est défectueux en vérifiant si le courant passant dans l'ensemble de cellules est inférieur d'au moins une fois le courant d'équilibrage à un courant passant dans celui-ci calculé sur le fondement d'une augmentation de tension de l'ensemble de cellules observée, et délivrer un message de défaut correspondant si tel n'est pas le cas.

7. Procédé conforme à l'une des revendications 1 à 6,
   **caractérisé par**,
   les étapes suivantes de la régénération consistant à :

   r1) augmenter la tension de l'ensemble de cellules (S25), et
   r2) vérifier si la tension de l'ensemble de cellules (U_Stack) n'a pas encore augmenté à une tension maximum (U_Max) (S26) et si aucun signal avertisseur n'apparaît (S27), si ces conditions ne sont pas remplies, recommencer les étapes r1) et r2), si la tension de l'ensemble de cellules a augmenté à la tension maximum (U_Max) terminer la régénération (S36), si un signal avertisseur apparait, augmenter la tension de l'ensemble de cellules (U_Stack) jusqu'à ce que la plus grande tension d'un groupe de cellules soit située à sa valeur maximum, la tension de l'ensemble de cellules (U_Stack) étant limitée à la tension nominale (U_Nenn) (S25, S29, S32), et vérifier si le signal avertisseur chute pendant une seconde durée définie (T_Krit) (S31, S34), si tel est le cas, recommencer les étapes r1) et r2), si tel n'est pas le cas, délivrer un message de défaut (S35) indiquant qu'il y a un défaut dans l'équilibrage.

**8.** Procédé conforme à l'une des revendications 1 à 7,
**caractérisé par** les étapes suivantes consistant à :

> f) fournir la quantité d'énergie nécessaire pour la régénération,
> g) détecter la libération de la quantité d'énergie nécessaire fournie, et
> h) jusqu'à l'obtention de cette libération, reprendre la mise en oeuvre des étapes b), f) et g) avant l'étape c), l'étape c) n'étant mise en oeuvre qu'après obtention de cette libération.

**9.** Procédé conforme à l'une des revendications 1 à 8,
**caractérisé en ce que**
la tension déterminée sur laquelle la tension de l'ensemble de cellules est réglée dans l'étape e) est égale à la moitié de la tension nominale (U_Nenn) de l'ensemble de cellules ou à la valeur médiane de la tension entre la tension pour laquelle il y a une sous-tension et la tension pour laquelle il y a une surtension.

FIG. 1

EP 1 997 205 B1

FIG. 2

EP 1 997 205 B1

Auswertung

Temp1

Supply

GND

Temp

CAP-Modul   Verbindung   Auswertung

GND

FIG. 3

FIG. 4

5j

5c

5b    5d    5a

out

5i

+

−

5e    5f

5g

AD-Kanal

5h

GND

5k

0

## FIG. 5

U

U_Nenn

U_GrenzO

U_Max

U_GrenzU

t

## FIG. 6

FIG. 7a

FIG. 7B

FIG. 7C

FIG. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10099407 A1
- EP 0851556 A2